# EUROPEAN PATENT APPLICATION

(11) **EP 2 602 632 A1**
(43) Date of publication of application: **12.06.2013**
(21) Application number: 11290566.6
(22) Date of filing: 06.12.2011
(51) Int. Cl.: G01R 31/34

(54) **Method for ascertaining a short-circuit in a stator core**

(71) Applicant: Alstom Technology Ltd., 5400 Baden (CH)
(72) Inventor: Graff, Hervé, 90300 Cravanche (FR)

(57) **Abstract**

The stator cores (1) have a plurality of laminations (3) insulated from one another. The method for ascertain a short circuit in the stator core (1) includes measuring the voltage of the laminations (3), determining the presence of a short circuit on the basis of the measured voltage.

## Description

### TECHNICAL FIELD

The present disclosure relates to a method for ascertain a short circuit in a stator core.

### BACKGROUND

Rotating electric machines have a stator core with a bore housing a rotor.

The stator core usually has a laminated structure that includes metal laminations with insulations interposed between adjacent laminations. This structure prevents eddy currents from circulating through the stator core during operation.

When the insulations fail and two or more laminations are short circuited, eddy currents can circulate; these eddy currents can generate high temperature spots that can cause lamination melting.

For these reasons, the short circuits must be detected to be counteracted.

In order to detect short circuits between laminations, it is known to operate the stator core with a low magnetic flux (few percentage of the nominal flux) such that eddy currents circulate between the short circuited laminations (this is usually done with an auxiliary winding); these eddy currents generate an additional magnetic flux that can be detected with a probe (such as a coil) that can be swept over the stator core.

This traditional method allows the area of the short circuit to be detected, but it does not allow the short circuited laminations to be identified to apply the required countermeasures only where required.

In addition, in case of small short circuits (i.e. when only two or few laminations are short circuited), this method does not allow the short circuit to be detected at all.

### SUMMARY

An aspect of the disclosure includes providing a method by which the short circuited laminations can be precisely identified.

Another aspect of the disclosure includes providing a method by which also small short circuits (i.e. short circuits regarding few laminations or also only two laminations) to be detected.

These and further aspects are attained by providing a method in accordance with the accompanying claims.

### BRIEF DESCRIPTION OF THE DRAWINGS

Further characteristics and advantages will be more apparent from the description of a preferred but non-exclusive embodiment of the method illustrated by way of non-limiting example in the accompanying drawings, in which:
Figure 1 is a schematic perspective view of a stator core;
Figures 2 through 4 are a longitudinal section of a stator core that is non-damaged (figure 2), damaged (figure 3), repaired (figure 4); and
Figures 5 through 8 show the measured voltage.

### DETAILED DESCRIPTION OF EMBODIMENTS OF THE INVENTION

The method is preferably implemented during manufacturing, when the stator does not house the rotor and usually with a test winding on the stator instead of the final winding. Use of test winding is not troubling because of the reduced supply current to the test winding and magnetic flux through the stator during the test.

In addition, the method can also be used during maintenance of the electric machine.

The part of the stator core that is usually more affected by short circuits between laminations is the stator bore; for example short circuits could be caused by tools that fall in the stator bore during manufacturing or maintenance and damage the insulation. For this reason the method is preferably implemented within the stator bore.

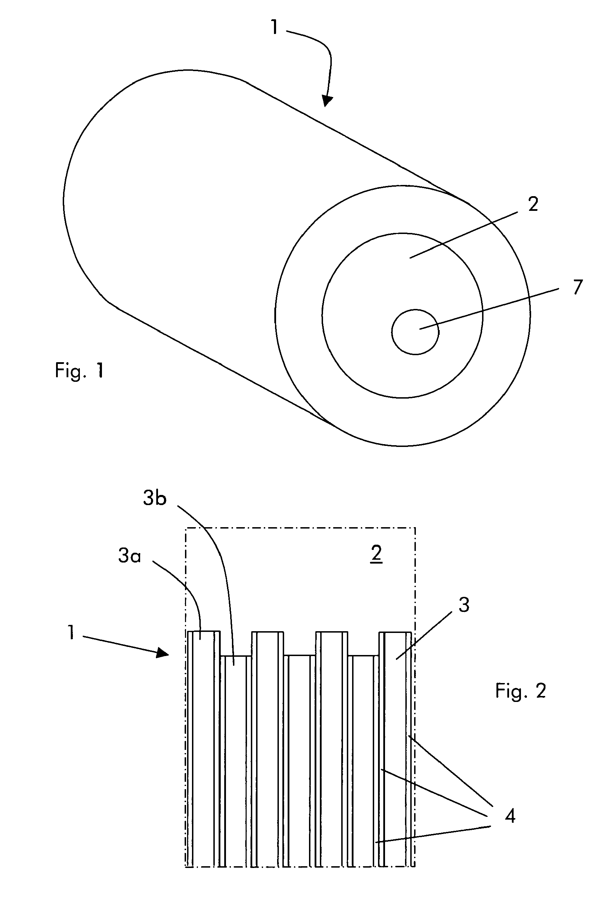

Figure 1 shows a stator core 1 that typically has an annular structure that defines a stator bore 2. Within the stator bore 2 a rotor is inserted; the rotor is not shown because it is usually not provided when the method is implemented.

The stator core 1 includes laminations 3 and insulation 4 between each couple of laminations 3.

As shown in figure 2 (that is a longitudinal section of a part of a stator core 1) the internal surface of the stator bore 2 has a comb like structure, with projecting laminations into the stator bore 2 that are alternated to non projecting laminations; in figure 2 reference 3a indicates a projecting lamination and reference 3b indicates a non projecting lamination. In different embodiments, instead of the comb like structure, the laminations can have the same size and define a straight longitudinal profile for the stator bore or can also have different configurations.

In order to insulate the laminations between each other, the insulations 4 cover the whole surface of the projecting laminations (i.e. also the projecting part thereof).

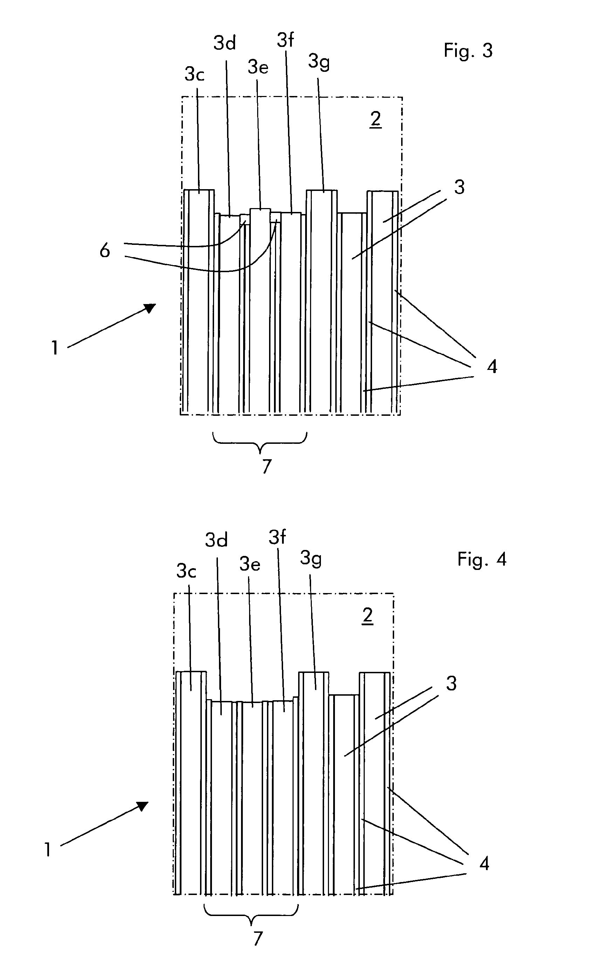

Figure 3 shows an example of damaged insulations between laminations 3 caused, for example, by a tool that falls during manufacturing or maintenance; anyhow it is clear that also other causes can cause insulation damage. In particular figure 3 shows the damaged laminations 3d, 3e, 3f and metal bridges 6 between adjacent laminations caused by the removal and/or bending and/or deformation of the metal of the damaged laminations and/or insulations.

In this case, in order to ascertain the short circuit the voltage of the laminations is measured and the presence of a short circuit is determined on the basis of the measured voltage.

A number of possibilities are available for measuring the voltage.

For example the voltage of all of the laminations 3 of an area to be tested can be measured together; this can be done with reference to an external reference voltage.

Preferably measuring the voltage of the laminations 3 includes measuring the voltage between two laminations 3.

In this respect, a lamination 3c can be used as a reference lamination and the voltage of the other laminations 3d-g can be measured with reference to it.

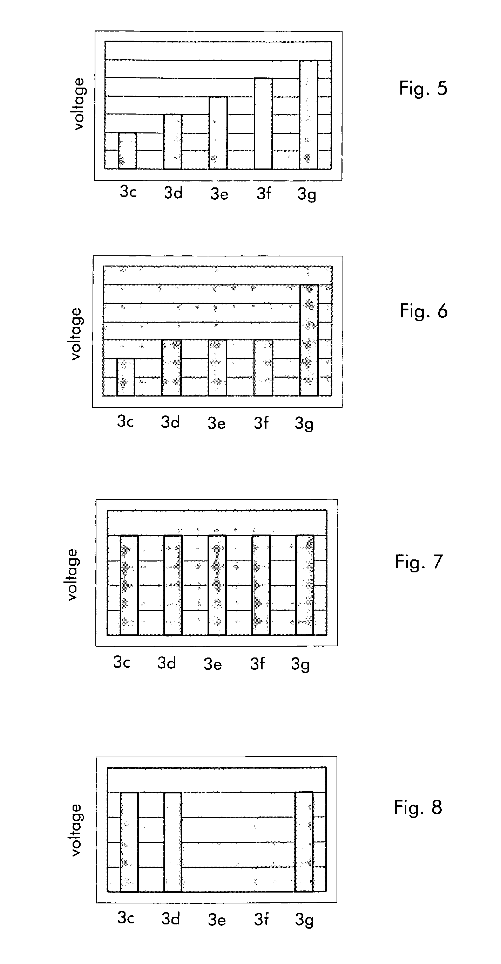

In this case, the voltage between the reference lamination 3c and the other laminations 3d-g is shown in figure 5 for a non-damaged stator core 1 and in figure 6 for a damaged stator core 1.

Alternatively, it is also possible measuring the voltage between adjacent laminations, thus with reference to figure 3 the voltage can also be measured between laminations 3c/3d, 3d/3e, 3e/3f, 3f/3g.

In this case, the voltage between the laminations 3c-g is shown in figure 7 for a non-damaged stator core 1 and in figure 8 for a damaged stator core 1.

The present method is preferably used in selected areas of the stator core.

For this reason it can be useful inspecting the stator core 1 before measuring the voltage of the laminations 3 to select one or more areas 7 to be further tested, because they seem troubling. Thus measuring the voltage of the laminations 3 can only be implemented at the selected area 7.

Inspecting can be done in different way.

It can be a visual inspection, or an inspection with the known method with low flux operation and coil to sense the generated flux by the eddy currents.

Once short circuits are identified, they can be removed, for example by milling; in this respect figure 4 shows an example of the stator core 1 whose area 7 has been subjected to milling to remove the short circuits.

Naturally the features described may be independently provided from one another.

In practice the materials used and the dimensions can be chosen at will according to requirements and to the state of the art.

### REFERENCE NUMBERS

- 1: stator core
- 2: stator bore
- 3, 3a-3g: lamination
- 4: insulation
- 6: bridge
- 7: area

## Claims

1. A method for ascertain a short circuit in a stator core (1) having a plurality of laminations (3) insulated from one another,
the method being **characterised by**
measuring the voltage of the laminations (3), determining the presence of a short circuit on the basis of the measured voltage.

2. The method according to claim 1, **characterised in that** measuring the voltage of the laminations (3) includes measuring the voltage between two laminations (3).

3. The method according to claim 2, **characterised by** measuring the voltage between a reference lamination (3c) and another lamination (3d-g).

4. The method according to claim 2, **characterised by** measuring the voltage between adjacent laminations (3c-g).

5. The method according to claim 1, **characterised by**
inspecting the stator core (1) before measuring the voltage of the laminations (3) to select at least an area (7) to be further tested, and
measuring the voltage of the laminations (3) only at the at least a selected area (7).
